# EUROPEAN PATENT APPLICATION

(11) **EP 4 560 279 A2**
(43) Date of publication of application: **28.05.2025**
(21) Application number: 24210376.0
(22) Date of filing: 01.11.2024
(51) Int. Cl.: G01L 9/00, G01L 9/06, G01L 9/08, G01L 19/00, G01L 19/04

(54) **PRESSURE TRANSDUCERS HAVING IMPROVED RESISTANCE TO TEMPERATURE ERROR**

(30) Priority: 03.11.2023 US 202363596029 P; 31.10.2024 US 202418933364
(71) Applicant: Illinois Tool Works Inc., Glenview IL 60025 (US)
(72) Inventor: FONTANA, Chris, Glenview, 60025 (US); MEI, Hai, Glenview, 60025 (US)
(74) Representative: HGF

(57) **Abstract**

Disclosed example pressure transducers include: a housing; a fluid inlet configured to provide a fluid to a first cavity within the housing; a pressure measurement assembly comprising a microelectromechanical pressure sensor configured to output a signal representative of the pressure in the first cavity; and a heater configured to heat the pressure measurement assembly based on a target temperature.

## Description

### RELATED APPLICATIONS

The present application claims the benefit of U.S. Provisional Patent Application Serial No. 63/596,029, filed November 3, 2024, entitled "PRESSURE TRANSDUCERS HAVING IMPROVED RESISTANCE TO TEMPERATURE ERROR." The entirety of U.S. Provisional Patent Application Serial No. 63/596,029 is expressly incorporated herein by reference.

### FIELD OF THE DISCLOSURE

This disclosure is directed generally to pressure transducers and, more particularly, to pressure transducers having improved resistance to temperature error.

### BACKGROUND

Pressure sensors, or pressure transducers, measure the pressure of a fluid input to the sensor compared to a reference pressure. Pressure sensors may be constructed to compare the input pressure to a fixed reference pressure or to a variable reference pressure.

### SUMMARY

Pressure transducers having improved resistance to temperature error are disclosed, substantially as illustrated by and described in connection with at least one of the figures, as set forth more completely in the claims.

### BRIEF DESCRIPTION OF THE DRAWINGS

These and other features, aspects, and advantages of the present disclosure will become better understood when the following detailed description is read with reference to the accompanying drawings in which like characters represent like parts throughout the drawings, wherein:
FIG. 1 is a block diagram of an example process control system including a pressure transducer having a fixed reference pressure, in accordance with aspects of this disclosure.
FIG. 2 is a schematic diagram of an example pressure sensor which may be used to implement the pressure sensor of FIG. 1, in accordance with aspects of this disclosure.
FIG. 3 is a perspective view of the example pressure measurement assembly of FIG. 2.
FIG. 4 is another perspective view of the example pressure measurement assembly of FIG. 2.

The figures are not necessarily to scale. Wherever appropriate, similar or identical reference numerals are used to refer to similar or identical components.

### DETAILED DESCRIPTION

For the purpose of promoting an understanding of the principles of the claimed technology and presenting its currently understood, best mode of operation, reference will be now made to the embodiments illustrated in the drawings and specific language will be used to describe the same. It will nevertheless be understood that no limitation of the scope of the claimed technology is thereby intended, with such alterations and further modifications in the illustrated device and such further applications of the principles of the claimed technology as illustrated therein being contemplated as would typically occur to one skilled in the art to which the claimed technology relates.

Conventional manometers use pressure measurement assemblies which have high accuracy over certain ranges. However, conventional manometers may have insufficient operational ranges and/or may have variable accuracy over subranges of the operational range. Additionally, conventional manometers may be unstable over the life of the sensor.

Disclosed example pressure transducers have higher accuracies and/or higher stability over the same operational pressures than conventional manometers. In particular, disclosed example pressure transducers include electromechanical pressure sensors which provide a high accuracy and stability, and which are packaged to reduce temperature-induced error. Due to the packaging and the nature of the electromechanical pressure sensors, disclosed example pressure transducers are less susceptible to errors caused by accumulation of contaminants in the process fluid.

Disclosed example pressure transducers include: a housing; a fluid inlet configured to provide a fluid to a first cavity within the housing; a pressure measurement assembly having a microelectromechanical pressure sensor configured to output a signal representative of the pressure in the first cavity; and a heater configured to heat the pressure measurement assembly based on a target temperature.

In some example pressure transducers, the microelectromechanical pressure sensor includes a trench etched resonant pressure sensor. In some example pressure transducers, the pressure measurement assembly includes a diaphragm at least partially defining the first cavity. In some example pressure transducers, the measurement diaphragm is configured to convey the pressure from the first cavity to the microelectromechanical pressure sensor. In some example pressure transducers, the pressure measurement assembly includes a sensor cavity, and the microelectromechanical pressure sensor is positioned within the sensor cavity. In some example pressure transducers, the sensor cavity further includes an incompressible fluid configured to convey the pressure applied by the diaphragm to the microelectromechanical pressure sensor.

In some example pressure transducers, the heater includes a first zone heater configured to heat the housing based on the target temperature, and a second zone heater configured to heat the pressure measurement assembly based on the target temperature. In some example pressure transducers, the microelectromechanical pressure sensor is configured to output pressure measurement signals for fluids having pressures at least from 1 Torr to 100 Torr and having less than a threshold error. In some example pressure transducers, the microelectromechanical pressure sensor is configured to output pressure measurement signals for fluids having pressures at least from 10 Torr to 1000 Torr and having less than a threshold error. In some example pressure transducers, the microelectromechanical pressure sensor is configured to output pressure measurement signals for fluids having pressures at least from 1 Torr to 1000 Torr and having less than a threshold error. In some example pressure transducers, the threshold error is less than 0.1500% reading.

Some example pressure transducers further include measurement circuitry configured to: apply a drive signal to the microelectromechanical pressure sensor; measure a frequency of a resulting signal output by the microelectromechanical pressure sensor; and determine a measured pressure based on the frequency. In some example pressure transducers, the pressure measurement assembly includes a plurality of electrodes extending from the pressure measurement assembly through the housing, and the measurement circuitry is configured to apply the drive signal via at least one of the electrodes.

In some example pressure transducers, the heater includes: a heating element configured to heat the pressure measurement assembly; a temperature sensor configured to measure a temperature of the pressure measurement assembly; and control circuitry configured to control the heating element based on the measured temperature.

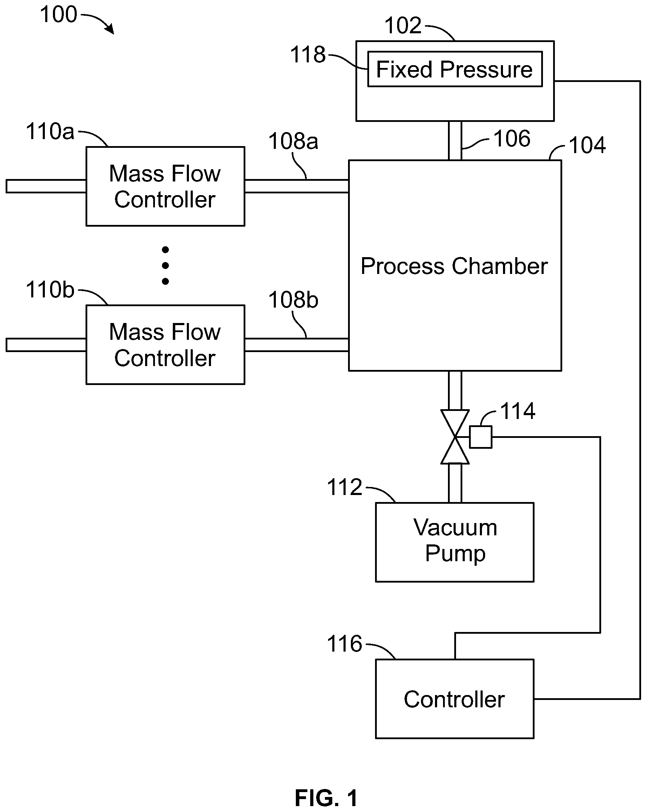

FIG. 1 is a block diagram of an example process control system 100 including a pressure transducer 102. The example process control system 100 of FIG. 1 includes a process chamber 104, to which the pressure transducer 102 is fluidly coupled via a fluid input line 106 to measure the pressure of the process chamber 104.

The example process chamber 104 may receive one or more inputs, such as process feed materials, via a corresponding number of feed lines 108a, 108b, which may be controlled via mass flow controllers 110a, 110b.

The example system 100 may include a vacuum pump 112, or other pressure control pump, and a valve 114 to control a flow rate between the vacuum pump 112 and the process chamber 104. The valve 114 may be controlled by a controller 116, computing device, and/or any other control technique, to maintain the pressure in the process chamber 104 within a desired range. The example pressure transducer 102 is communicatively coupled to the controller 116 to provide pressure feedback to the controller 116 (e.g., for use in a pressure control loop). For example, as the pressure in the process chamber 104 increases, the pressure transducer 102 measures the pressure and provides a signal representative of the pressure to the controller 116, which then controls the valve 114 to increase the flow rate from the process chamber 104 to the vacuum pump 112. The vacuum pump 112 may have an output to any appropriate location based on the nature of the process.

In the example of FIG. 1, the pressure transducer 102 is configured with a fixed pressure 118, to which an input pressure of a fluid received via the fluid input line 106 is compared to output a pressure signal. For example, as discussed in more detail below, the pressure transducer 102 may be provided with a sealable evacuation port which may be sealed when the desired pressure is provided within the pressure transducer 102, and/or the pressure transducer 102 may be assembled and sealed within a volume having the desired reference pressure. The fixed pressure 118 may be a vacuum pressure or another predetermined fixed reference pressure which may be below, at, or above a nominal atmospheric pressure. In the configuration of FIG. 1, the pressure transducer 102 may be used as an absolute pressure sensor.

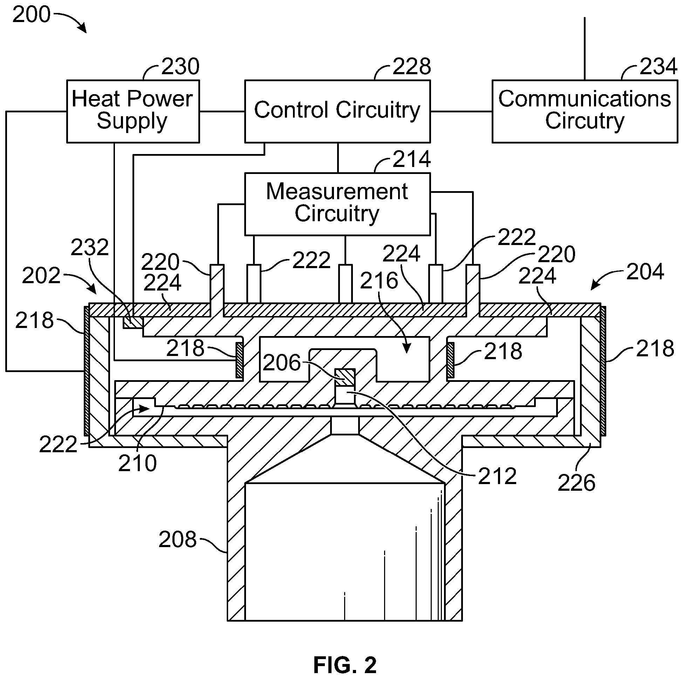

FIG. 2 is a schematic diagram of an example pressure transducer 200 which may be used to implement the pressure transducer 102 of FIG. 1. The example pressure transducer 200 includes a pressure measurement assembly 202 and a housing 204. The pressure transducer 200 receives a fluid via a fluid input line 208 (e.g., the fluid input line 106 of FIG. 1), measures the absolute pressure of the received fluid, and outputs one or more signals representative of the measured pressure.

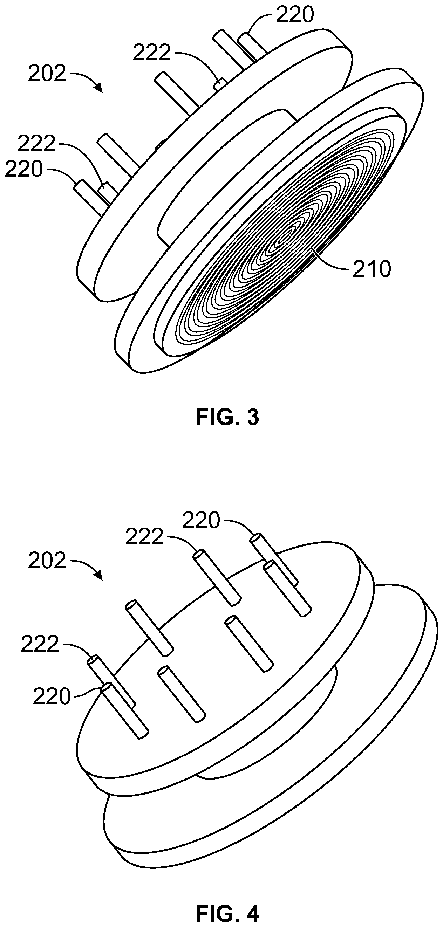

FIG. 3 is a perspective view of the example pressure measurement assembly 202 of FIG. 2. FIG. 4 is another perspective view of the example pressure measurement assembly 202 of FIG. 2. With reference to FIG. 2, the pressure measurement assembly 202 defines a measurement cavity 222 which is attached to the fluid input line 208. The example fluid input line 208 is also secured and sealed to the housing 204 (e.g., via a flange). The pressure measurement assembly 202 may also be referred to as the "sensor core," in that the pressure measurement assembly 202 performs the measurements which are converted to output signals. The pressure measurement assembly 202 is at least partially surrounded by the housing 204. The housing 204 may provide thermal insulation and/or physical protection to the pressure measurement assembly 202.

In the illustrated example, the pressure measurement assembly 202 includes a microelectromechanical pressure sensor 206 coupled to a diaphragm 210. In some examples, the microelectromechanical pressure sensor 206 is a trench etched resonant pressure sensor or other silicon micro-machined in-plane resonating structure, in which the microelectromechanical pressure sensor 206 outputs an output signal having a resonant frequency based on the pressure applied to the diaphragm 210. An example trench etched resonant pressure sensor that may be used to implement the microelectromechanical pressure sensor 206 is described in "Advances in Core Fundamental Sensor Technologies Enabling Improvements in the Metrological Transfer Standards of Pressure Measurement," Moisoi, et al., Metrologist - NCSLI Worldwide News, Vol. 15, No. 2, pp. 46-55 (2002) ("Moisoi"). The entirety of Moisoi is incorporated herein by reference.

The diaphragm 210 is subjected to the pressure in the measurement cavity 222, and transfers the pressure to the microelectromechanical pressure sensor 206 via an incompressible fluid within a sensor cavity 212. The microelectromechanical pressure sensor 206 is positioned at a far end of the sensor cavity 212 from the diaphragm 210, and the incompressible fluid fills the remainder of the sensor cavity 212. In some examples, the incompressible fluid is an incompressible oil, which may further be electrically non-conductive. Additionally or alternatively, the microelectromechanical pressure sensor 206 includes a second diaphragm, such as a silicon diaphragm, to electrically insulate the microelectromechanical pressure sensor 206 from the incompressible fluid while transferring force from the fluid to the resonance components of the microelectromechanical pressure sensor 206.

The diaphragm 210 may have an increased or decreased diameter to further increase or decrease the sensitivity of the pressure measurement assembly 202.

The microelectromechanical pressure sensor 206 is coupled to measurement circuitry 214 via ports 220, 222 for supply of an input signal and/or providing the output signal. The pressure measurement assembly 202 may define a thermal oven chamber 216, which is in fluid communication with an ambient pressure. The example microelectromechanical pressure sensor 206 may have an integrated pressure reference which is sealed into the microelectromechanical pressure sensor 206. For example, a silicon diaphragm within the microelectromechanical pressure sensor 206 separates the pressure reference from the sensor cavity 212, and a resonating element of the microelectromechanical pressure sensor 206 resides within the reference pressure cavity of the microelectromechanical pressure sensor 206. The microelectromechanical pressure sensor 206 measures the pressure applied against the diaphragm 210 with respect to the reference pressure in the integrated pressure reference . The integrated pressure reference in the microelectromechanical pressure sensor 206may be established, for example, at the construction of the microelectromechanical pressure sensor 206.

In the example of FIG. 2, the surface of the diaphragm 210 has circular convolutions, which may be concentric with the diaphragm 210, and allow the axial deflection of the diaphragm 210 with minimal change of internal tension to improve linearity of the microelectromechanical pressure sensor 206. Because the pressure on the diaphragm 210 is measured by the microelectromechanical pressure sensor 206 (e.g., by measuring a change in the resonance frequency of a driven circuit), increasing the linear movement of the diaphragm 210 improves the precision of the microelectromechanical pressure sensor 206.

The pressure transducer 200 further includes one or more heaters 218 to increase the temperature of the microelectromechanical pressure sensor 206 (e.g., to reduce effects caused by thermal gradients between the microelectromechanical pressure sensor 206 and the process fluid(s)). The example heater 218 may be positioned around an outside of the housing 204 and/or within the housing 204 and around the outside of the pressure measurement assembly 202. In some examples, the heater(s) 218 are controlled to heat the microelectromechanical pressure sensor 206 to a setpoint temperature which, in some cases, is at least the expected process temperature of the fluid received via the fluid input line 208. In some examples, one or more heat spreaders are positioned in contact between the heater(s) 218 and the housing 204 and/or between the heater(s) 218 and the microelectromechanical pressure sensor 206 to more effectively distribute heat over a larger area of the housing 204 and/or the microelectromechanical pressure sensor 206 and reduce thermal gradients. The housing 204 may be constructed using a thermally conductive material to reduce temperature gradients within the housing 204. Additional and/or alternative locations for heaters 218 may include a bottom surface of the second body 226, a top surface of the first body 224, and/or around the fluid input line 208.

The heaters 218 may improve the measurement precision by the microelectromechanical pressure sensor 206 and/or the stability of measurement over the lifetime of the microelectromechanical pressure sensor 206, over a wide range of input pressures. The heater(s) 218 may further protect against longer-term error due to processinduced shift. While two example heaters 218 are illustrated as heating two different zones in FIG. 2, the pressure transducer 200 may include more or fewer heaters 218 and/or more or fewer heating zones.

In some examples, the microelectromechanical pressure sensor 206 is configured to output pressure measurement signals having less than a threshold error for fluids having pressures at least from 1 Torr to 100 Torr (e.g., a pressure range which includes at least 1 Torr to 100 Torr, and may include pressures below 1 Torr and/or pressures above 100 Torr). In some examples, the microelectromechanical pressure sensor 206 is configured to output pressure measurement signals having less than a threshold error for fluids having pressures at least from 10 Torr to 1000 Torr. In some examples, the microelectromechanical pressure sensor 206 is configured to output pressure measurement signals having less than a threshold error for fluids having pressures at least from 1 Torr to 1000 Torr. An example threshold error is 0.1500% of the measurement output (reading). In other examples, the pressure transducer 200 may be configured to use other pressure ranges as the operational range, which may include 2-decade ranges or 3-decade ranges (on the Torr scale) and/or larger operational ranges, while maintaining less than the threshold error over the operational range.

The pressure transducer 200 further includes control circuitry 228, which receives measurements from the measurement circuitry 214, controls a heater power supply 230 to provide power to the heater 218, and receives a temperature feedback signal from the heater 218 and/or a temperature sensor 232 on the sensor housing 204.

The control circuitry 228 may be implemented using at least one controller or processor that controls the operations of the pressure transducer 200. The control circuitry 228 receives and processes multiple inputs. The control circuitry 228 may include one or more microprocessors, such as one or more "general-purpose" microprocessors, one or more specialpurpose microprocessors and/or ASICS, and/or any other type of processing device. For example, the control circuitry 228 may include one or more digital signal processors (DSPs). The control circuitry 228 may further include memory devices and/or data storage devices.

The example measurement circuitry 214 is connected to output ports 220 to receive the measurement signal(s), and/or to input ports 222 to provide an input or drive signal to drive a resonance of the microelectromechanical pressure sensor 206. For example, the measurement circuitry 214 may apply a drive signal to the microelectromechanical pressure sensor 206 via the input ports 222, measure a frequency of a resulting signal output by the microelectromechanical pressure sensor 206 via the output ports 220, and determine a measured pressure based on the frequency. For example, the measurement circuitry 214 may be calibrated after construction for a set of frequencies and pressures.

Additional ports may provide heating power to the heaters 218 and/or temperature sensor data from the temperature sensor 232 for the control circuitry 228 to control the heaters 218.

The housing 204 includes a first body 224 and a second body 226. The second body 226 is coupled to the fluid input line 208. For example, the second body 226 may be welded, brazed, or otherwise coupled to the fluid input line 208 to facilitate or improve heat transfer. The first body 224 is coupled to the second body 226 to enclose the pressure measurement assembly 202 within the housing 204. The first body 224 may further include openings through which the ports 220, 222 extend for connection to the measurement circuitry 214 and/or the control circuitry 228.

The example microelectromechanical pressure sensor 206 has a reduced sensitivity to contamination on the diaphragm 210 (e.g., particulate from the input line 208), compared to conventional capacitive sensors in which the diaphragm is part of the capacitance electrode and the sensor output is a function of the displacement of the diaphragm. Instead of relying on the sensitivity of the diaphragm 210 to affect a capacitance, the diaphragm 210 transfers the pressure in the measurement cavity 222 to the incompressible fluid within the sensor cavity 212. As such, the example pressure transducer 200 may extend the life of the microelectromechanical pressure sensor 206 in contamination-prone applications, and the microelectromechanical pressure sensor 206 may be packaged into a smaller package than conventional sensors by, for example, eliminating a guard volume that reduces contamination on the diaphragm.

The example pressure transducer 200 may further include communications circuitry 234 to communicate the measurements to an external computing or control device (e.g., the controller 116 of FIG. 1). For example, the communications circuitry 234 may include any wired and/or wireless communications circuitry. In some examples, the communications circuitry 234 performs digital communications to transmit digital measurement values output by the measurement circuitry 214. By using digital communications, such as EtherCAT, precision measurements made using the microelectromechanical pressure sensor 206 are preserved during the communications. The communications circuitry 234 may further receive command signals, which are provided to the control circuitry 228. Example command signals include configuration information, such as a target heating temperature, a temperature reporting interval, and/or any other desired configuration information.

The present devices and/or methods may be realized in hardware, software, or a combination of hardware and software. The present methods and/or systems may be realized in a centralized fashion in at least one computing system, processors, and/or other logic circuits, or in a distributed fashion where different elements are spread across several interconnected computing systems, processors, and/or other logic circuits. Any kind of computing system or other apparatus adapted for carrying out the methods described herein is suited. A typical combination of hardware and software may be a processing system integrated into a welding power source with a program or other code that, when being loaded and executed, controls the welding power source such that it carries out the methods described herein. Another typical implementation may comprise an application specific integrated circuit or chip such as field programmable gate arrays (FPGAs), a programmable logic device (PLD) or complex programmable logic device (CPLD), and/or a system-on-a-chip (SoC). Some implementations may comprise a non-transitory machine-readable (e.g., computer readable) medium (e.g., FLASH memory, optical disk, magnetic storage disk, or the like) having stored thereon one or more lines of code executable by a machine, thereby causing the machine to perform processes as described herein. As used herein, the term "non-transitory machine readable medium" is defined to include all types of machine readable storage media and to exclude propagating signals.

As utilized herein, "and/or" means any one or more of the items in the list joined by "and/or". As an example, "x and/or y" means any element of the three-element set {(x), (y), (x, y)}. In other words, "x and/or y" means "one or both of x and y". As another example, "x, y, and/or z" means any element of the seven-element set {(x), (y), (z), (x, y), (x, z), (y, z), (x, y, z)}. In other words, "x, y and/or z" means "one or more of x, y and z". As utilized herein, the term "exemplary" means serving as a non-limiting example, instance, or illustration. As utilized herein, the terms "e.g.," and "for example" set off lists of one or more non-limiting examples, instances, or illustrations.

While the present method and/or system has been described with reference to certain implementations, it will be understood by those skilled in the art that various changes may be made, and equivalents may be substituted without departing from the scope of the present method and/or system. For example, block and/or components of disclosed examples may be combined, divided, re-arranged, and/or otherwise modified. In addition, many modifications may be made to adapt a particular situation or material to the teachings of the present disclosure without departing from its scope. Therefore, the present method and/or system are not limited to the particular implementations disclosed. Instead, the present method and/or system will include all implementations falling within the scope of the appended claims, both literally and under the doctrine of equivalents.

## Claims

1. A pressure transducer, comprising:
a housing;
a fluid inlet configured to provide a fluid to a first cavity within the housing;
a pressure measurement assembly comprising a microelectromechanical pressure sensor configured to output a signal representative of the pressure in the first cavity; and
a heater configured to heat the pressure measurement assembly based on a target temperature.

2. The pressure transducer as defined in claim 1, wherein the microelectromechanical pressure sensor comprises a trench etched resonant pressure sensor.

3. The pressure transducer as defined in claim 1, wherein the pressure measurement assembly comprises a diaphragm at least partially defining the first cavity.

4. The pressure transducer as defined in claim 3, wherein the measurement diaphragm is configured to convey the pressure from the first cavity to the microelectromechanical pressure sensor.

5. The pressure transducer as defined in claim 4, wherein the pressure measurement assembly comprises a sensor cavity, the microelectromechanical pressure sensor positioned within the sensor cavity.

6. The pressure transducer as defined in claim 5, wherein the sensor cavity further comprises an incompressible fluid configured to convey the pressure applied by the diaphragm to the microelectromechanical pressure sensor.

7. The pressure transducer as defined in claim 1, wherein the heater comprises:
a first zone heater configured to heat the housing based on the target temperature; and
a second zone heater configured to heat the pressure measurement assembly based on the target temperature.

8. The pressure transducer as defined in claim 1, wherein the microelectromechanical pressure sensor is configured to output pressure measurement signals for fluids having pressures at least from 1 Torr to 100 Torr and having less than a threshold error.

9. The pressure transducer as defined in claim 1, wherein the microelectromechanical pressure sensor is configured to output pressure measurement signals for fluids having pressures at least from 10 Torr to 1000 Torr and having less than a threshold error.

10. The pressure transducer as defined in claim 1, wherein the microelectromechanical pressure sensor is configured to output pressure measurement signals for fluids having pressures at least from 1 Torr to 1000 Torr and having less than a threshold error.

11. The pressure transducer as defined in claim 10, wherein the threshold error is less than 0.1500% reading.

12. The pressure transducer as defined in claim 1, further comprising measurement circuitry configured to:
apply a drive signal to the microelectromechanical pressure sensor;
measure a frequency of a resulting signal output by the microelectromechanical pressure sensor; and
determine a measured pressure based on the frequency.

13. The pressure transducer as defined in claim 12, wherein the pressure measurement assembly comprises a plurality of electrodes extending from the pressure measurement assembly through the housing, and the measurement circuitry is configured to apply the drive signal via at least one of the electrodes.

14. The pressure transducer as defined in claim 1, wherein the heater comprises:
a heating element configured to heat the pressure measurement assembly;
a temperature sensor configured to measure a temperature of the pressure measurement assembly; and
control circuitry configured to control the heating element based on the measured temperature.
